Europäisches Patentamt

European Patent Office

Office européen des brevets

(19)

(11) Veröffentlichungsnummer: **0 175 184**
**B1**

(12) **EUROPÄISCHE PATENTSCHRIFT**

(45) Veröffentlichungstag der Patentschrift: **18.07.90**

(51) Int. Cl.⁵: **G 01 N 24/08**

(21) Anmeldenummer: **85110861.3**

(22) Anmeldetag: **29.08.85**

(54) Verfahren zum Messen der magnetischen Kernresonanz.

(30) Priorität: **18.09.84 DE 3434161**

(43) Veröffentlichungstag der Anmeldung:
**26.03.86 Patentblatt 86/13**

(45) Bekanntmachung des Hinweises auf die
Patenterteilung:
**18.07.90 Patentblatt 90/29**

(84) Benannte Vertragsstaaten:
**DE FR GB NL**

(56) Entgegenhaltungen:
EP-A-0 074 022
EP-A-0 158 965
GB-A-2 052 753
GB-A-2 056 078

PROCEEDINGS OF THE IEEE, Band 70, Nr. 10,
Oktober 1982, Seiten 1152-1173, IEEE, New
York, US; Z.H. CHO et al.: "Fourier transform
nuclear magnetic resonance tomographic
imaging"

(73) Patentinhaber: **Bruker Medizintechnik GmbH
Silberstreifen
D-7512 Rheinstetten-Forchheim (DE)**

(72) Erfinder: **Hennig, Jürgen
Johann-von-Weerth-Strasse 12
D-7800 Freiburg (DE)**
Erfinder: **Nauerth, Arno
Herrenmühlweg 1
D-6741 Erlenbach (DE)**

(74) Vertreter: **Patentanwälte Kohler - Schwindling -
Späth
Hohentwielstrasse 41
D-7000 Stuttgart 1 (DE)**

## Beschreibung

Die Erfindung betrifft ein Verfahren zum Messen der magnetischen Kernresonanz in ausgewählten Bereichen eines Körpers zum Zwecke der Bilddarstellung von Körperquerschnitten (NMR-Tomographie), bei dem der Körper außer einem homogenen Magnetfeld einem Selektionsgradienten ausgesetzt und mit einem 90°-Impuls angeregt, danach der Selektionsgradient durch zeitlich begrenzte Phasencodierungs- und Lesegradienten ersetzt und schließlich der Körper mit einer Folge von 180°-Impulsen, die zusammen mit dem 90°-Impuls eine Carr-Purcell-Gill-Meiboom-Impulsfolge (CPGM-Folge) bilden und auf deren Erscheinen die Einschaltdauer und Stärke der Gradientenfelder derart abgestimmt ist, daß für alle Gradientenfelder die Rephasierungsbedingungen erfüllt sind, bestrahlt wird, wodurch für jede Anregung mehrere Kerninduktionssignale in Form sogenannter Spinechos erzeugt werden, die dann nach dem 2D-FT-Bildrekonstruktionsverfahren rechnerisch zu Bildsignalen verarbeitet werden.

Ein solches Verfahren ist in der zum Stand der Technik gehörenden europäischen Patentanmeldung EP—A 0 158 965 beschrieben. Diese am 23.10.85 veröffentlichte europäische Anmeldung genießt die Priorität vom 18.04.84 und gilt als Stand der Technik gemäß Artikel 54(3) und (4) EPÜ. In dieser Patentanmeldung sind verschiedene Möglichkeiten behandelt, die Rephasierungsbedingungen bei Anwendung einer CPGM-Folge zu erfüllen. Die Erfüllung der Rephasierungsbedingungen ist Voraussetzung dafür, daß solche CPGM-Folgen bei der NMR-Tomographie und insbesondere zur Erzeugung von Bildern nach dem 2D-FT-Verfahren verwendet werden können. Die Verletzung der Rephasierungsbedingungen hat Bildfehler zur Folge, welche bis dahin die Anwendung solcher CPGM-Folgen bei der NMR-Tomographie weitgehend ausschlossen.

Wie in der herkömmlichen NMR-Spektrographie hat auch bei dem bekannten Verfahren die Anwendung von CPGM-Folgen den Zweck, eine Vielzahl gleichartiger Signale zu erhalten, die entweder zur Verbesserung des Signal-Rausch-Verhältnisses aufaddiert werden können oder aber Informationen über die zeitliche Entwicklung der Spinechos liefern, also insbesondere über die Spin-Spin-Relaxationszeit $T_2$.

Die vorliegende Erfindung befaßt sich jedoch nicht mit dem Problem des Signal-Rausch-Verhältnisses sowie einer genauen $T_2$-Bestimmung. Die praktische Anwendung der NMR-Tomographie leidet bis heute unter der Notwendigkeit, eine Vielzahl von Einzelmessungen vorzunehmen, um die für eine Bildrekonstruktion erforderlichen Meßwerte zu erhalten, und der Tatsache, daß die für jede einzelne Messung benötigte Zeit relativ lang ist, weil sie die vor jeder neuen Anregung abzuwartende Relaxationszeit umfaßt. Insofern scheinen einer Verkürzung der Meßzeit physikalisch bedingte Grenzen gesetzt.

Trotzdem liegt der Erfindung die Aufgabe zugrunde, bei der NMR-Tomographie eine deutliche Verminderung der Meßzeit zu erzielen.

Diese Aufgabe wird nach der Erfindung dadurch gelöst, daß die Stärke und/oder Dauer des Phasencodierungsgradienten nach jedem 180°-Impuls geändert wird.

Bei dem erfindungsgemäßen Verfahren wird also die Verwendung von CPGM-Folgen beim 2D-FT-Verfahren nicht dazu verwendet, durch Verarbeitung der mittels einer Anregung erzielten Vielzahl von Spinechos das Signal-Rausch-Verhältnis zu verbessern oder eine genaue $T_2$-Bestimmung vorzunehmen, sondern es wird durch Veränderung des Phasencodierungsgradienten nach jedem 180°-Impuls eine Vielzahl unterschiedlicher Echosignale erhalten, die in Abhängigkeit vom Phasencodierungsgradienten in unterschiedlicher Weise für den Bildinhalt verantwortlich sind und nach dem 2D-FT-Bildrekonstruktionsverfahren verarbeitet werden können. Auf diese Weise ist es möglich, als Reaktion auf nur wenige und im Grenzfall auf nur eine Anregung die Echosignale zu erhalten die für eine Bildrekonstruktion erforderlich sind. Das erfindungsgemäße Verfahren führt demnach zu einer Reduzierung der Meßzeiten auf einen Bruchteil des bisher Notwendigen, was insbesondere für die Anwendung der NMR-Tomographie in der Humanmedizin von außerordentlicher Bedeutung ist.

Das 2D-FT-Bildrekonstruktionsverfahren geht an sich davon aus, daß die bei jeder der auszuwertenden Einzelmessungen erhaltenen Signale für einen vorgegebenen Intensitätswert eines Bildpunktes die gleiche Amplitude haben. Diese Bedingung ist bei Anwendung des erfindungsgemäßen Verfahrens nicht erfüllt, da die Signalamplitude mit zunehmendem zeitlichen Abstand von der Anregung infolge der Relaxationsvorgänge abnimmt. Das Ergebnis ist eine gewisse Verminderung der Bildqualität, die sich in einer Hintergrund-Aufhellung äußert, die aber gerade im medizinischen Bereich leicht in Kauf genommen werden kann, da es dort mehr auf den Kontrast zwischen Gewebe mit unterschiedlichen $T_2$-Werten ankommt. Der $T_2$-Kontrast kann jedoch bei dem erfindungsgemäßen Verfahren variiert werden, indem die Zuordnung der unterschiedlichen Phasencodierungsgradienten zu den aufeinanderfolgenden 180°-Impulsen geändert wird. Insbesondere kann dann, wenn zur Rekonstruktion des Bildes die Echosignale von mehreren Anregungen verwendet werden, eine verschachtelte Zuordnung der unterschiedlichen Werte des Phasencodierungsgradienten zu den den einzelnen Anregungen zugeordneten Echosignalen erfolgen, durch die eine Aufhellung des Bildhintergrundes weitgehend vermieden wird. Allerdings tritt dann bei anwendung gleicher CPGM-Folgen eine Art Stufung bezüglich der Amplituden der einzelnen Echosignale ein, die zu störenden Seitenbanden Anlaß gibt. Es gibt jedoch eine einfache Möglichkeit zur Beseitigung von Stufen und damit von solchen störenden Seitenbanden, die darin besteht, daß in weiterer Ausgestaltung der Erfindung bei jeder Anregung der zeitliche Abstand zwischen dem 90°-Impuls und dem ersten 180°-Impuls um einen zur Anzahl der Wiederholungen umgekehrt proportionalen Bruchteil des Abstandes zwischen den 180°-Impulsen variiert wird. Hierdurch lassen sich die bei den verschiedenen Anregungen erzielten Echosignale in bezug auf den Anregungszeitpunkt derart gegeneinander verschieben, daß sie auf das durch eine Anregung definierte Meßintervall gleichmäßig verteilt sind. Damit repräsentieren sie eine kontinuierliche Abnahme der Signalamplitude und nicht die zu Seitenbanden führende Stufung.

Die Erfindung bietet nicht nur die Möglichkeit, durch geschickte Zuordnung der verschiedenen Werte der Phasencodierungsgradienten zu den zeitlich aufeinanderfolgenden Echosignalen eine Verstärkung des $T_2$-Kontrastes herbeizuführen, sondern sie gestattet auch eine Beeinflussung und insbesondere Erhöhung des $T_1$-Kontrastes, indem bei wiederholter Anregung der Probe jede erneute Anregung erfolgt, bevor eine vollständige Relaxation der durch die vorangegangene CPGM-Folge angeregten Spinmomente stattgefunden hat. Als Folge dieser Maßnahme werden die Spinmomente, die infolge von großem $T_1$ noch nicht relaxiert haben, von der nächsten Anregung nicht erfaßt und liefern daher keine Signale, so daß der Kontrast zu Bereichen mit kurzem $T_1$ verstärkt wird, in denen eine vollständige Relaxation der Spinmomente stattgefunden hat, die nunmehr ein volles Signal liefern.

Die sehr kurze Meßzeit, die zur Ermittlung der für das 2D-FT-Bildrekonstruktionsverfahren erforderlichen Meßwerte benötigt wird, bietet auch die Möglichkeit, die Erfindung bei einem 3D-FT-Bildrekonstruktionsverfahren anzuwenden. Der besondere Vorteil des Bildrekonstruktionsverfahrens mit 2D-Fouriertransformation besteht darin, daß es auch dann sehr gute Bilder liefert, wenn die Homogenität des Magnetfeldes nicht sehr groß ist. Dieser Vorteil des Verfahrens würde sich bei seiner Ausdehnung auf das dreidimensionale Volumen noch bedeutend erhöhen. Die durch die Erfindung mögliche, bedeutende Reduzierung der Meßzeit läßt nunmehr diese Ausdehnung auf den dreidimensionalen Raum zu. Demgemäß erstreckt sich die Erfindung auch auf ein Verfahren, bei dem als Selektionsgradient ein weiterer Phasencodierungsgradient verwendet wird und die Bildrekonstruktion nach dem 3D-FT-Verfahren erfolgt.

Die Erfindung wird im folgenden anhand der in der Zeichnung dargestellten Ausführungsbeispiele näher beschrieben und erläutert. Die der Beschreibung und der Zeichnung zu entnehmenden merkmale können bei anderen Ausführungsformen der Erfindung einzeln für sich oder zu mehreren in beliebiger Kombination Anwendung finden. Es zeigen:

Fig. 1 das Zeitdiagramm einer CPGM-Impulsfolge und der Gradientenfelder, wie sie bei einer Ausführungsform des erfindungsgemäßen Verfahrens Anwendung finden,

Fig. 2 u. 3 Diagramme, die den Einfluß der Zuordnung der unterschiedlichen Phasengradienten zu den verschiedenen Echosignalen auf den Bildkontrast veranschaulichen,

Fig. 4 ein Diagramm zur Erläuterung der Verschachtelung von Aufnahmesequenzen in bezug auf den Phasengradienten und

Fig. 5 ein Diagramm, das eine modifizierte CPGM-Folge zur Vermeidung von Bildfehlern wiedergibt.

Das erfindungsgemäße Verfahren läßt sich auf jedem NMR-Tomograph durchführen, dessen Sender zur Erzeugung von HF-Impulsfolgen eingerichtet ist und dessen Magnetanordnung die Erzeugung schaltbarer Gradientenfelder in drei aufeinander senkrecht stehenden Richtungen gestattet, von denen einer mit der Richtung des zur Erzeugung von NMR-Spektren notwendigen, homogenen Magnetfeldes zusammenfällt. Ein geeigneter Tomograph ist beispielsweise der Ganzkörpertomograph vom Typ BMT 1100 der Anmelderin.

Bei dem erfindungsgemäßen Verfahren handelt es sich seinem Wesen nach um ein 2D-FT-Verfahren, bei dem der vorzugsweise selektiv im Bereich einer Querschnittsebene angeregte Körper vor Einschalten des Lesegradienten einem zeitlich begrenzten Phasencodierungsgradienten ausgesetzt wird. Die aufgrund der Anregung und Phasencodierung erhaltenen Spinechos werden einer zweidimensionalen Fourier-Transformation unterworfen, welche einzelnen Bildpunkten zugeordnete Signale liefert, deren Amplitude der Intensität der Bildpunkte proportional ist. Für jedes aufzulösende Volumenelement, d.h. für jeden Bildpunkt, ist eine Projektion, d.h. die Erzeugung eines Spinechos, nach Anlegen eines anderen Phasencodierungsgradienten erforderlich. Da bisher für die Erzeugung eines Spinechos unter einem eigenen, zugordneten Phasengradienten eine gesonderte Anregung der Probe erforderlich war, ergab sich für die Erzeugung eines Bildes nach dem 2FT-Verfahren ein erheblicher Zeitaufwand.

Bei dem erfindungsgemäßen Verfahren wird stattdessen eine Spinecho-Impulsfolge verwendet und vor der Erzeugung jedes neuen Echosignales ein geänderter Phasencodierungsgradient angelegt, so daß jedes einzelne Spinecho einer Echofolge, welche durch eine einzige Anregung erzeugt worden ist, für eine andere Projektion charakteristisch ist. Voraussetzung ist allerdings, daß im Verlauf der Impulsfolge und der wiederholt angelegten Phasencodierungs- und Lesegradienten keine Veränderungen im Anregungszustand der Spinmomente eintreten, welche eine Bildverfälschung zur Folge haben. Es muß daher dafür Sorge getragen werden, daß für den Lesegradienten und auch den Phasencodierungsgradienten die Rephasierungsbedingungen erfüllt sind, d.h. daß für die verwendete Carr-Purcell-Gill-Meiboom-Impulsfolge die Gill-Meiboom-Bedingung erfüllt ist.

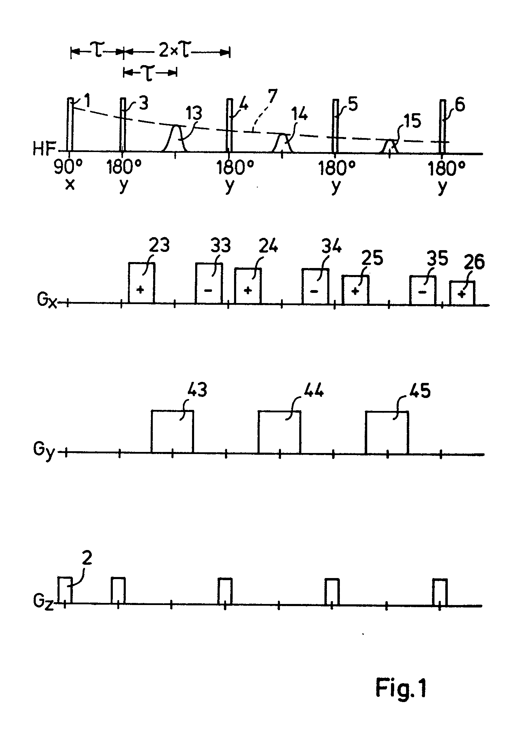

Ein Beispiel für eine Impuls- und Gradientenfeld-Sequenz, bei welcher die Gill-Meiboom-Bedingung erfüllt ist, ist in Fig. 1 dargestellt. Diese Sequenz umfaßt eine übliche CPGM-Folge von HF-Impulsen mit einem ersten 90°-Impuls 1, durch den die Probe bei Anliegen eines Selektionsgradienten $G_z$ selektiv im Bereich einer durch den Selektionsgradienten definierten Querschnittsebene angeregt wird. Dem 90°-Selektionsimpuls 1 folgen dann in üblicher Weise 180°-Impulse 3, 4, 5, 6, die eine Rephasierung der durch den Selektionsimpuls 1 angeregten und nach der Anregung dephasierenden Spinmomente bewirken, so daß es in bekannter Weise zur Ausbildung von Spinechos 13, 14, 15 kommt, die in dem gleichen zeitlichen Abstand τ vom vorausgehenden 180°-Impuls erscheinen wie ihn dieser 180°-Impuls vom Selektionsimpuls 1 bzw. dem vorhergehenden Spinecho besitzt. Bei dem dargestellten Ausführungsbeispiel sind alle diese Abstände gleich.

Die für das 2D-FT-Verfahren erforderliche Phasencodierung wird durch Anlegen eines Phasencodierungsgradienten $G_x$ bewirkt, und zwar wird dieser Gradient jeweils im Anschluß an einen 180°-Impuls eingeschaltet und vor Erscheinen des Spinechos wieder beendet. In Fig. 1 ist das Einschalten des Phasencodierungsgradienten durch die impulsartigen Kurvenzüge 23, 24, 25, 26 veranschaulicht. Die unterschiedliche Höhe dieser Kurvenzüge zeigt an, daß der Phasencodierungsgradient jedesmal eine andere Stärke hat, so daß er eine unterschiedliche Phasencodierung zur Folge hat. Die durch die unterschliedlichen Phasencodierungsgradienten bewirkten Phasencodierungen müssen jedoch stets vom gleichen Anfangszustand ausgehen, wenn sie auswertbare Ergebnisse liefern sollen. Daher ist es notwendig, die Wirkung jeder Phasencodierung aufzuheben, bevor eine neue Phasencodierung stattfindet. Dies erfolgt bei dem dargestellten Ausführungsbeispiel des erfindungsgemäßen Verfahrens durch Anlegen des Phasencodierungsgradienten mit gleicher Stärke und Dauer, jedoch umgekehrter Wirkungsrichtung, symmetrisch zum Auftreten des Echosignales, wie es die Kurven 33, 34 und 35 anzeigen. Die Wirkung des umgekehrten oder negativen Phasencodierungsgradienten 33 auf die dephasierenden Spinmomente ist genau so groß wie die Wirkung des vorhergehenden Phasencodierungsgradienten 23 auf die rephasierenden Spinmomente, so daß zum Zeitpunkt des 180°-Impulses 4 genau der gleiche Phasenzustand herrscht, wie zum Zeitpunkt des vorhergehenden 180°-Impulses 3. Entsprechendes gilt für die Phasencodierungsgradienten 24, 34 bzw. 25, 35 usf.

Entsprechend ist auch für eine zum Echosignal symmetrische Anordnung des Lesegradienten 43, 44, 45 dafür Sorge getragen, daß dessen Einfluß auf das rephasierende und das dephasierende Spinsystem völlig gleich ist, so daß sich auch der Einfluß des Lesegradienten aufhebt.

Dans Anliegen des Selektionsgradienten $G_z$ während der 180°-Impulse, wie es bei dem dargestellten Verfahren stattfindet, ist dann nicht notwendig, wenn es sich bei den 180°-Impulsen um Breitbandimpulse handelt. Das erfindungsgemäße Verfahren ermöglicht jedoch das Anlegen des Selektionsgradienten während der 180°-Impulse, so daß hier frequenzselektive Impulse verwendet werden können, wobei es sich im Gegensatz zu Breitband-Impulsen um Impulse relativ langer Dauer und geringer Energie handeln kann. Auch hier ist durch eine symmetrisch Anordnung des Selektionsgradienten zu den 180°-Impulsen dafür Sorge getragen, daß die Phasenverhältnisse des Spinsystems nicht gestört werden.

Es versteht sich, daß das dargestellte Impuls- und Gradientenfeld-System nicht das einzige mögliche ist, um die Rephasierungsbedingungen oder die Gill-Meiboom-Bedingung zu erfüllen. In der europäischen Patentanmeldung 85 104 326.5 sind mehrere Möglichkeiten behandelt, um die Rephasierungsbedingungen einzuhalten. Diese Möglichkeiten werden hiermit durch die Bezugnahme auf die ältere Patentanmeldung zum Gegenstand dieser Anmeldung gemacht. Das erfindungsgemäße Verfahren ist nicht von der Anwendung einer bestimmten Impuls- und Gradientenfeld-Sequenz abhängig, sofern nur dafür Sorge getragen ist, daß die Gill-Meiboom-Bedingung erfüllt ist. Die Anwendung der herkömmlichen CPGM-Folge und dazu symmetrisch angeordneter Gradientenfelder gleicher Stärke hat den Vorteil, daß solche Impuls- und Feld-Sequenzen mit besonders geringem Aufwand erzeugt werden können.

Trotz Einhalten der Rephasierungs- oder CPGM-Bedingung ist nicht zu vermeiden, daß infolge von Relaxationsprozessen die Amplitude des Spinechos 13, 14, 15 entsprechend der Relaxationskurve 7 abnimmt, wie es Fig. 1 zeigt. Als Folge davon sind die Einzelpunkte des erhaltenen Bildes mit der diesen Bildpunkten zugeordneten, unterschiedlichen Relaxationsfunktionen gewichtet. Erfolgt die Bildaufnahme mit M-Echos pro Anregung und werden für die Erzeugung eines Bildes P Projektionen oder Echosignale mit unterschiedlichem Phasencodierungsgradient benötigt, um eine Bildmatrix der Größe $B \times B = P$ zu rekonstruieren, so läßt sich jedes eine Projektion darstellende Echosignal $E_{m,p}$ als Summe der der von den einzelnen Bildelementen stammenden Signalen $S_{x,y}$ Bildelemente auffassen:

$$E_{m,p} = \Sigma\, S_{x,y} \qquad (1)$$

$$m = 1 \ldots M \qquad x = 1 \ldots B$$
$$p = 1 \ldots P \qquad y = 1 \ldots B$$

Da die Amplitude der von den einzelnen Bildelementen stammenden Signale $S_{x,y}$ mit der Relaxationsfunktion $R_{x,y}(t)$ des Pixels abfällt, gilt

$$S_{x,y} = A_{x,y} \cdot R_{x,y}(m.2\tau) \qquad (2),$$

wenn $A_{x,y}$ der Anfangswert der Signalamplitude und $2\tau$ der zeitliche Abstand zwischen den 180°-Impulsen der CPGM-Folge ist.

Dementsprechend wird Gl.(1) zu

$$E_{m,p} = \Sigma A_{x,y} \cdot R_{x,y}(m.2\tau). \qquad (3)$$

Die einzelnen Echosignale sind also mit der Relaxationsfunktion der einzelnen Bildpunkte gewichtet, und dementsprechend sind auch die die Intensität der einzelnen Bildpunkte wiedergebenen, durch die Fourier-Transformation erhaltenen Signale mit der Relaxationsfunktion der Pixel gewichtet. Diese Gewichtung ist von der Zuordnung der P Phasencodierungsgradienten zu den M der bei jeder Anregung erhaltenen Echosignale abhängig. Diese Zuordnung kann willkürlich gewählt werden, wodurch es möglich ist, den durch die Gewichtung bedingten Bildkontrast für verschiedene Anwendungen zu variieren.

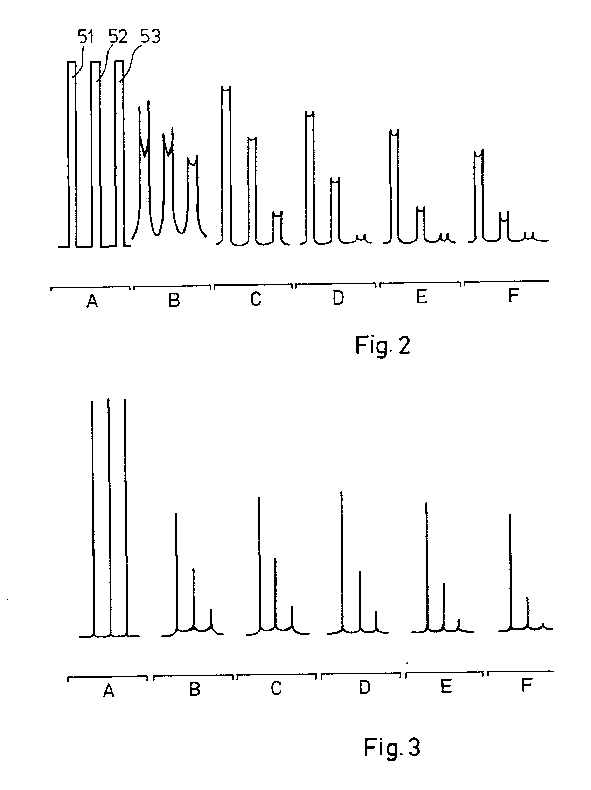

Es sei zunächst der Fall betrachtet, in dem die Anzahl M der Echos pro Anregung und die Anzahl P der Projektionen mit verschiedenem Phasencodierungsgradienten gleich ist, so daß also das gesamte Bild mit einer einzigen Anregung aufgenommen wird. Dabei kann die Veränderung des Phasencodierungsgradienten so erfolgen, daß beim ersten Echo die Dephasierung $\varphi 7_{min}$ und beim letzten Echo die Dephasierung $\varphi 7_{max}$ vorliegt. Dabei kann der Nullpunkt der Phasenverschiebung an eine beliebige Stelle der Echofolge gelegt werden. Die Fig. 2 und 3 veranschaulichen den Einfluß der Verschiebung des Phasennullpunktes an verschiedene Stellen für Strukturen mit unterschiedlichen $T_2$-Zeiten.

In Fig. 2 veranschaulichen die Balken 51, 52, 53 die sich aus der Spindichte ergebende Signalintensität drei verschiedener Bereiche mit unterschiedlichen Relaxationszeiten $T_2$ unmittelbar nach der Anregung, also noch unbeeinflußt von der Relaxation. Der Bereich 51 hat ein langes $T_2$, der Bereich 52 ein mittleres und der Bereich 53 ein kurzes $T_2$.

Die Felder B bis F der Fig. 2 geben die Intensitäten der gleichen bereich 51 bis 53 wieder, wie sie im Feld A der Fig. 2 dargestellt sind, wie sie sich bei Anwendung des erfindungsgemäßen Verfahrens und Verschieben des Nullpunktes des Phasengradienten gegenüber den angeregten Echosignalen ergeben. Die Intensitäten des Feldes B erhält man, wenn bei einer Aufnahme von 256 Echosignalen der Nullpunkt des Phasengradienten beim Echo Nr. 32 vorliegt. Entsprechend liegt der Nullpunkt des Phasengradienten für die Signale des Feldes C beim Echo 64, für die Signale des Feldes D beim Echo 96, für die Signale des Feldes E beim Echo 128 und für die Signale des Feldes F beim Echo 1. Es ist ersichtlich, daß sich sowohl die absolute Höhe der Signale ändert als auch das Verhältnis der Signale, die Bereichen mit unterschiedlichem $T_2$ zugeordnet sind. Eine maximale Signalamplitude bei sehr gutem Kontrast ergibt sich im Feld C. Zu beachten ist die Signalüberhöhung an den Rändern der Bereiche, die auf die Abnahme der Amplitude der Echosignale infolge der Relaxation zurückzuführen ist. Fig. 3 zeigt eine der Fig. 2 analoge Darstellung von Signalintensitäten, die jedoch nicht auf Bereiche, sondern auf einzelne Bildpunkte bezogen sind.

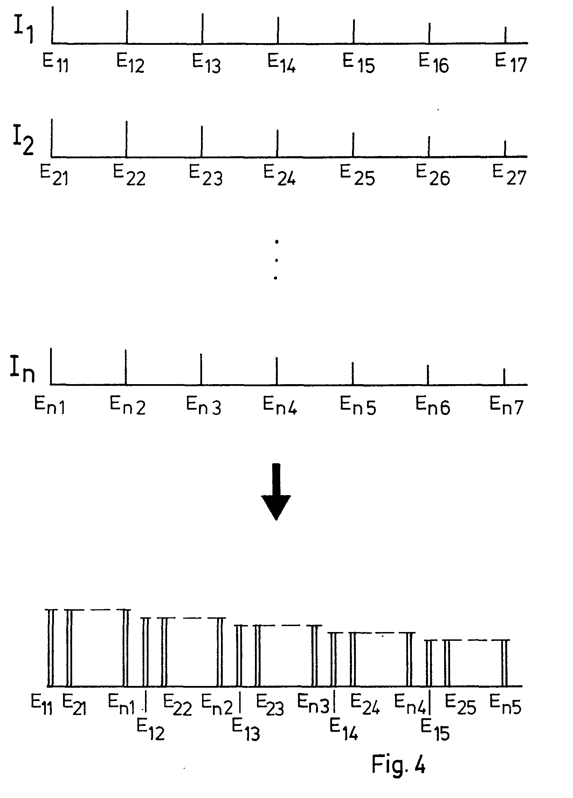

Erfolgt die Bildaufnahme mit mehr als einer Anregung, so kann der Phasengradient auf die Echosignale der verschiedenen Anregungen in der Weise verteilt werden, daß er bei der ersten Anregung von $\varphi_{min}$ bis $\varphi_1$, bei der nächsten Anregung von $\varphi_1$ bis $\varphi_2$ und bei der letzten Anregung endlich von einem Wert $\varphi_n$ bis $\varphi_{max}$ ansteigt. Es kann aber auch eine Verschachtelung vogenommen werden, wie sie in Fig. 4 für die durch Anregungen $I_1$ bis $I_n$ hervorgerufenen Echos veranschaulicht ist. Diese Verschachtelung, wie sie in der letzten Zeile von Fig. 4 dargestellt ist, ist in Bezug auf einen gleichmäßig von $\varphi_{min}$ bis $\varphi_{max}$ ansteigenden Phasengradienten zu verstehen, so daß den ersten aufeinanderfolgenden Werten des Phasengradienten jeweils die ersten Echosignale $E_{11}$ bis $E_{n1}$ der verschiedenen Anregungen $I_1$ bis $I_n$ zugeordnet sind, worauf dann die zweiten Echosignale $E_{12}$ bis $E_{n2}$ der verschiedenen Anregungen folgen usw. Dabei entsteht allerdings eine Amplitudenstufung, welche die Bildqualität stark beeinträchtigen kann. Diese Stufung kann jedoch dadurch beseitigt werden, daß durch Modifikation des Anregungsvorganges die bei den verschiedenen Anregungen hervorgerufenen Echosignale gegenseitig derart verschoben werden, daß sie alle den gleichen zeitlichen Abstand voneinander haben und infolgedessen auch eine der Relaxationskurve folgende, stetig abnehmende Amplitude. Zu diesem Zweck genügt es, bei jeder Anregung den zeitlichen Abstand zwischen dem 90°-Impuls und dem ersten 180°-Impuls um einen zur Anzahl der Wiederholungen umgekehrt proportionalen Bruchteil des Abstandes zwischen den 180°-Impulsen zu variieren.

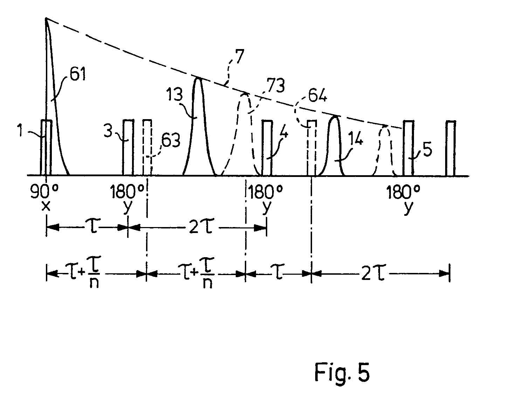

In Fig. 5 ist nochmal der Beginn einer CPGM-Folge mit den dadurch erhaltenen Echosignalen dargestellt. Der 90°-Selektionsimpuls 1 verursacht ein erstes Induktionssignal 61, das normalerweise nicht ausgewertet wird. Die Dephasierung des Signals wird dann nach einer Zeit $\tau$ durch den 180°-Impuls 3 rückgängig gemacht, so daß es wiederum nach einer Zeit $\tau$ zur Rephasierung und damit zur Erzeugung des Echosignales 13 kommt. Darauf folgen dann, bezogen auf den ersten 180°-Impuls, weitere 180°-Impulse 4, 5 usw. jeweils im Abstand von $2\tau$, die entsprechende Echosignale hervorrufen, von denen in Fig. 5 noch das Echosignal 14 dargestellt ist. Die Amplitude der Echosignale nimmt entsprechend der Relaxationskurve 7 ab. Insoweit stimmt Fig. 5 mit Fig. 1 überein.

Um bei mehreren Anregungen eine relative zeitliche Verschiebung der Echosignale zu erhalten, wird bei der nächsten Anregung der Abstand des 180°-Impulses vom 90°-Impuls um $\tau/n$ verlängert, wenn n die Anzahl der vorgesehenen Anregungen ist. Infolgedessen erscheint auch das durch den zeitlich verzögerten 180°-Impuls 63 hervorgerufene Echosignal 73 im Abstand $\tau + \tau/n$ vom 180°-Impuls 63, so daß er gegenüber dem ersten Echosignal 13 der ersten Anregung um die Zeit $2\gamma/n$ verschoben ist. Der nächste 180°-Impuls 64 wird dann wieder im Abstand $\tau$ vom Echosignal 73 erzeugt, so daß von nun an der Impuls-

und Signalabstand 2τ verwendet und die zuvor erzielte Verschiebung der Echosignale über die gesamte Folge erhalten bleibt. In Fig. 5 ist der Fall für n = 3 dargestellt. Bei der nächsten Anregung findet wiederum eine zusätzliche Verschiebung um τ/n statt, so daß eine gleichmäßige zeitliche Verschachtelung sämlicher Echosignale erzielt wird.

Bezogen auf das erste Echosignal 73 kann der anhand Fig. 5 erläuterte Vorgang auch als eine Vorverlegung des Anregungszeitpunktes um 2τ/n betrachtet werden. Anstatt der beschriebenen Verlängerung der Zeiten zwischen dem 90°-Impuls und ersten 180°-Impuls mit der entsprecenden Verlängerung der Zeit zwischen dem ersten 180°-Impuls und dem ersten Echo um jeweils τ/n könnte auch der 90°-Impuls schon nach der Zeit τ/n von einem 180°-Impuls gefolgt werden, der das Erzeugen eines Echosignales nach einer weiteren Zeit τ/n zur Folge hat. Damit ist ein um 2τ/n gegenüber dem 90°-Impuls verschobener Rephasierungszustand erreicht, auf den dann die weiteren 180°-Impulse bezogen werden können, so daß kann der nächste 180°-Impuls um 2τ/n gegenüber den 180°-Impulsen der ersten Sequenz versetzt ist. Die gleiche Wirkung könnte auch dadurch erzielt werden, daß die durch den 90°-Imuls erzielte Anregung durch einen Spin-Locking-Puls der Dauer 2τ/n erhalten wird. Die Anwendung der beschriebenen Methoden führt wieder zu einem mit der Relaxationsfunktion multiplizierten Echo, wie es oben erläutert worden ist. Allerdings erscheint die Dwell-Zeit für die 2D-Fourier-Transformation um den Faktor 1/n verkürzt, was zu einer Verminderung des $T_2$-Kontrastes des Bildes führt, da nun auch Pixel mit kurzen $T_2$-Zeiten noch dargestellt werden.

Die Erfindung ist nicht auf die beschriebenen Ausführungsformen des erfindungsgemäßen Verfahrens beschränkt. Einerseits macht es die hohe Aufnahmegeschwindigkeit möglich, das Verfahren auch zu einem 3D-FT-Verfahren auszuweiten, bei dem ein Selektionsgradient in Form eines weiteren Phasencodierungsgradienten angewendet wird, für den die gleichen Gesichtspunkte gelten wie für den oben behandelten Phasencodierungsgradient $G_x$, bei dessen Anlegen also dafür Sorge getragen werden muß, daß die Rephasierungs-Bedingungen, d.h. also die Gill-Meiboom-Bedingung, eingehalten ist. Weiterhin besteht die Möglichkeit, durch eine Variation der Wiederholrate zwischen den einzelnen Anregungen noch einen $T_1$-Kontrast im Bild zu erzielen. Wird das Anregungsintervall so kurz gewählt, daß Spins mit großem $T_1$ noch nicht relaxiert haben, so werden diese Spins bei der nächsten Anregung nicht erfaßt und können daher auch kein Signal liefern. Daraus ergibt sich ein deutlicher Intensitätsunterschied zwischen Gebieten mit großen und kleinem $T_1$.

**Patentansprüche**

1. Verfahren zum Messen der magnetischen Kernresonanz in ausgewählten Bereichen eines Körpers zum Zwecke der Bilddarstellung von Körperquerschnitten (NMR-Tomographie), bei dem der Körper außer einem homogenen Magnetfeld einem Selektionsgradienten ausgesetzt und mit einem 90°-Impuls angeregt, danach der Selektionsgradient durch zeitlich begrenzte Phasencodierungs- und Lesegradienten ersetzt und schließlich der Körper mit einer Folge von 180°-Impulsen, die zusammen mit dem 90°-Impuls eine Carr-Purcell-Gill-Meiboom-Impulsfolge (CPGM-Folge) bilden und auf deren Erscheinen die Einschaltdauer und Stärke der Gradientenfelder derart abgestimmt ist, daß für alle Gradientenfelder die Raphasierungsbedingungen erfüllt sind, bestrahlt wird, wodurch für jede Anregung mehrere Kerninduktionssignale in Form sogenannter Spinechos erzeugt werden, die dann nach dem 2D-FT-Bildrekonstruktionsverfahren rechnerisch zu Bildsignalen verarbeitet werden, wobei die Stärke und/oder Dauer des Phasencodierungsgradienten nach jedem 180°-Impuls geändert wird.

2. Verfahren nach Anspruch 1, dadurch gekennzeichnet daß der Körper mehrmals hintereinander mit einer CPGM-Folge angeregt und bei den aufeinanderfolgenden Anregungen unterschiedlichen Phasengradienten ausgesetzt wird.

3. Verfahren nach Anspruch 2, dadurch gekennzeichnet, daß bei jeder Anregung der zeitliche Abstand zwischen dem 90°-Impuls und dem ersten 180°-Impuls sowie zwischen den beiden ersten 180°-Impulsen um einen zur vorgegebenen Anzahl der Wiederholungen umgekehrt proportionalen Bruchteil des konstanten Abstandes zwischen den übrigen 180°-Impulsen vergrößert wird.

4. Verfahren nach Anspruch 2 oder 3, dadurch gekennzeichnet, daß jede erneute Anregung erfolgt, bevor eine vollständige Relaxation der durch die vorangegangene CPGM-Folge angeregten Spinmomente stattgefunden hat.

5. Verfahren nach eiem der vorhergehenden Ansprüche, dadurch gekennzeichnet, daß als Selektionsgradient ein weiterer Phasencodierungsgradient verwendet wird und die Bildrekonstruktion nach dem 3D-FT-Verfahren erfolgt.

**Revendications**

1. Procédé pour mesurer la résonance magnétique nucléaire dans des régions choisies d'un corps en vue de la représentation d'images de coupes du corps (tomographie R.M.N.), dans lequel le corps, outre un champ magnétique homogène, est soumis à un gradient de sélection et excité par une impulsion à 90°, puis le gradient de sélection est remplacé par des gradients de modulation de phase et de lecture limités dans le temps, et le corps est enfin irradié par un train d'impulsions à 180° qui forment avec l'impulsion à 90° un train d'impulsions de Carr-Purcell-Gill-Meiboom (train d'impulsions CPGM), et à l'apparition desquelles sont associées la durée d'application et l'intensité des champs de gradients, de telle sorte que les conditions de remise en phase soient remplies pour tous les champs de gradients, ce qui engendre pour chaque excitation plusieurs signaux d'induction nucléaire sous la forme de ce que l'on appelle des échos de spin qui sont ensuite traités par le calcul selon le procédé de reconstitution de l'image par transformées de Fourier à deux dimensions pour fournir des signaux d'images, l'intensité et/ou la durée des gradients de modulation de phase étant modifiée après chaque impulsion à 180°.

2. Procédé selon la revendication 1, caractérisé par le fait que le corps est excité plusieurs fois l'une après l'autre par un train d'impulsions CPGM, et qu'il est soumis à des gradients de phases différents lors des excitations successives.

3. Procédé selon la revendication 2, caractérisé par le fait que, lors de chaque excitation, l'intervalle dans le temps entre l'impulsion à 90° et la première impulsion à 180°, ainsi qu'entre les deux premières impulsions à 180, est augmenté d'une fraction de l'intervalle constant entre les autres impulsions à 180° qui est inversement proportionnelle au nombre prédéterminé des répétitions.

4. Procédé selon la revendication 2 ou 3, caractérisé par le fait que chaque nouvelle excitation se produit avant qu'ait lieu une relaxation complète des moments de spin excités par le train d'impulsions CPGM précédent.

5. Procédé selon l'une des revendications précédentes, caractérisé par le fait que l'on utilise comme gradient de sélection un autre gradient de modulation de phase, et que la reconstitution de l'image a lieu selon le procédé par transformées de Fourier à trois dimensions.

**Claims**

1. Method for measuring the nuclear magnetic resonance in selected areas of a body for imaging crss-sections thereof (NMR tomography), in which the body is exposed to a selection gradient in addition to a homogeneous magnetic field and is excited with a 90° pulse, subsequently the selection gradient is replaced by time-limited phase encoding and reading gradients and finally the body is irradiated with a sequence of 180° pulses which, together with the 90° pulse, form a Carr-Purcell-Gill-Meiboom pulse sequence (CPGM sequence) and to whose appearance the on-time and intensity of the gradient field in matched in such a way that the rephasing conditions are fulfilled for all the gradients fields, so that for each excitation several nuclear induction signals are produced in the form of spin echos, which are then mathematically processed to image signals according to the 2D-FT image reconstruction process, the intensity and/or duration of the phase encoding gradients being modified after each 180° pulse.

2. Method according to claim 1, characterized in that the body is excited several times in succession with a CPGM sequence and during successive excitations is exposed to different phase gradients.

3. Method according to claim 2, characterized in that during each excitation the time interval between the 90° pulse and the first 180° pulse, as well as between the first two 180° pulses is increased by a fraction of the constant interval between the other 180° pulses inversely proportional to the given number of repeats.

4. Method according to claims 2 or 3, characterized in that each further excitation takes place before there has been a complete relaxation of the spin moments excited by the preceding CPGM sequence.

5. Method according to one of the preceding claims characterized in that the selection gradient is constituted by a further phase encoding gradient and image reconstruction takes place according to the 3D-FT method.

Fig.1

Fig. 2

Fig. 3

$I_1$
$E_{11}$ $E_{12}$ $E_{13}$ $E_{14}$ $E_{15}$ $E_{16}$ $E_{17}$

$I_2$
$E_{21}$ $E_{22}$ $E_{23}$ $E_{24}$ $E_{25}$ $E_{26}$ $E_{27}$

$I_n$
$E_{n1}$ $E_{n2}$ $E_{n3}$ $E_{n4}$ $E_{n5}$ $E_{n6}$ $E_{n7}$

$E_{11}$ $E_{21}$ $E_{n1}$ $E_{22}$ $E_{n2}$ $E_{23}$ $E_{n3}$ $E_{24}$ $E_{n4}$ $E_{25}$ $E_{n5}$
$E_{12}$ $E_{13}$ $E_{14}$ $E_{15}$

Fig. 4

3

Fig. 5